Europäisches Patentamt

European Patent Office

Office européen des brevets

(11) Publication number: **0 501 414 A1**

## EUROPEAN PATENT APPLICATION

(21) Application number: 92103166.2

(22) Date of filing: 25.02.92

(51) Int. Cl.5: **H01R 23/68**, G02F 1/1345

(30) Priority: **28.02.91 JP 33291/91**

(43) Date of publication of application:
**02.09.92 Bulletin 92/36**

(84) Designated Contracting States:
**DE FR GB IT NL**

(71) Applicant: **ROHM CO., LTD.**
**21, Saiin Mizosaki-cho Ukyo-ku**
**Kyoto-shi Kyoto 615(JP)**

(72) Inventor: **Hirai, Minoru, c/o Rohm Co., Ltd.**
**21, Saiin Mizosaki-Cho, Ukyo-Ku**
**Kyoto-Shi, Kyoto 615(JP)**

(74) Representative: **Glawe, Delfs, Moll & Partner**
**Patentanwälte**
**Postfach 26 01 62 Liebherrstrasse 20**
**W-8000 München 26(DE)**

(54) **A method for connecting electrodes of a display apparatus.**

(57) A method of connecting electrodes of a display apparatus includes a process of forming conductive metal paste on an electrode pattern on a flexible resin plate where a drive circuit device is mounted and a process of position-adjusting the electrode pattern on which the conductive metal paste is provided and the electrode pattern on a plane-type display body to heat and pressurize them. By this method, the electrode pattern on the display body and the electrode pattern on the drive circuit side are connected to each other through the conductive metal paste.

Fig. 6

## BACKGROUND OF THE INVENTION

Field of the Invention

The present invention relates to a method of connecting electrodes of a plane-type display apparatus such as a liquid crystal display apparatus, a plasma display apparatus and an electro-luminescent display apparatus.

Description of the Prior Art

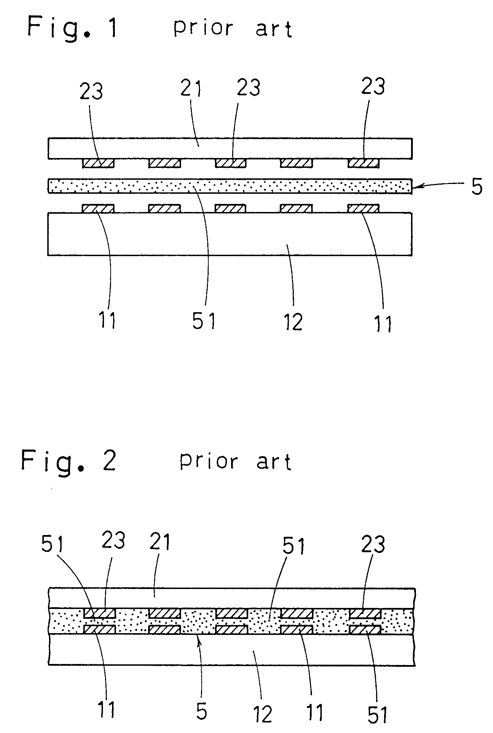

Liquid crystal display apparatuses are constructed by connecting an electrode pattern arranged on a connecting portion of a liquid crystal panel and an electrode pattern of an external drive circuit device which is formed with an integrated circuit (IC) device. According to a conventional electrode connecting method, as shown in Fig. 1, an electrode pattern 23 on a flexible resin plate (such as a flexible printed circuit plate) 21 where a drive IC device is mounted and an electrode pattern 11 on a connection portion 12 of a liquid crystal panel are connected by applying anisotrapically conductive adhesive 5 therebetween and heating and pressurizing them.

According to the above electrode connecting method, as shown in Fig. 2, the electrode patterns 11 and 23 are connected through the anisotrapically conductive adhesive (thermoplastic or thermosetting resin where conductive particles 51 such as carbon, nickel, solder, etc. are dispersed) 5. That is, the electrode patterns 11 and 23 opposite to each other in a vertical direction are electrically enabled by the conductive particles 51 in the resin, and the pasting thereof is achieved through the resin. However, the adhesive strength of the resin is weak against heat stress. Because of this, there are occasions when the electrode patterns 11 and 23 are not completely pasted together due to heat stress acting on the resin in response to a change in temperature. This makes the method less reliable.

## SUMMARY OF THE INVENTION

An object of the present invention is to provide a method of connecting electrodes of a display apparatus which produces a result of high resistance to heat stress and high quality reliability.

To achieve the above-mentioned object, a method of connecting electrodes of a display apparatus comprising a process of forming conductive metal paste on an electrode pattern on a flexible resin plate where a drive circuit device is mounted and a process of position-adjusting the electrode pattern on which the conductive metal paste is provided and the electrode pattern on a plane-type display body to heat and pressurize them, wherein the electrode pattern on the display body and the electrode pattern on the drive circuit side are connected to each other through the conductive metal paste.

According to such a method of connecting electrodes, since electrodes are connected not by a resin pasting but by a metal paste pasting, adhesive strength highly resistant to heat is obtained, whereby high quality reliability is realized.

## BRIEF DESCRIPTION OF THE DRAWINGS

This and other objects and features of this invention will become clear from the following description taken in conjunction with the preferred embodiments with reference to the accompanied drawings in which:

Fig. 1 is an explanatory view showing a conventional method of connecting electrode of a display apparatus;

Fig. 2 is an explanatory view showing a condition where electrodes are connected by the conventional method of connecting electrode of a display apparatus;

Fig. 3 is a side view of a main portion of a display apparatus where electrodes are connected by a method of the present invention;

Figs. 4 and 5 are process views where carbon paste is being transferred onto electrode patterns on a flexible resin plate in a method of the present invention;

Fig. 6 is a process view where the electrode patterns and liquid crystal patterns on the flexible resin are arranged opposite to each other in the method of the present invention;

Fig. 7 is a process view where the electrode pattern on the flexible resin plate and the electrode pattern on the display panel are conductively pasted together through the carbon paste in the method of the present invention; and

Fig. 8 is a process view showing one process of another embodiment of the present invention.

## DESCRIPTION OF THE PREFERRED EMBODIMENTS

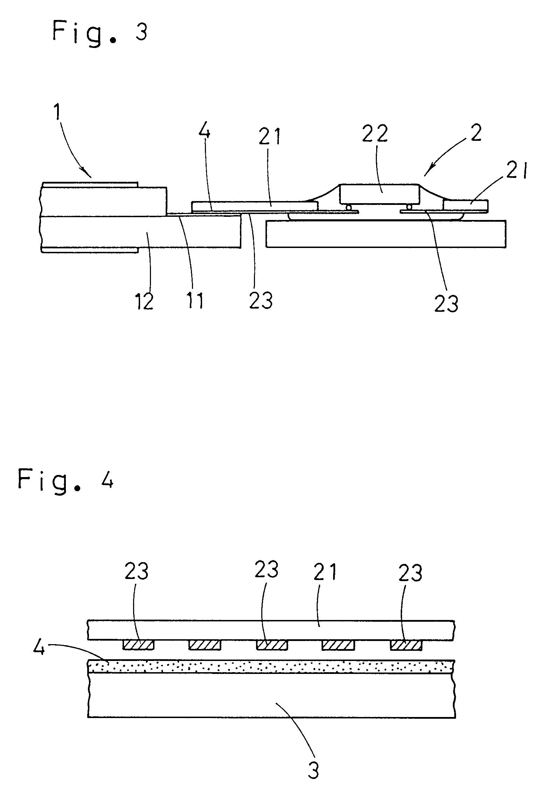

Fig. 3 shows a main portion of a display apparatus constructed by a method of connecting electrodes of a display apparatus according to the present invention.

A display apparatus consists of a display panel (display body) 1 and an external circuit portion 2 which is electrically coupled to the display body 1. In the external circuit portion 2, a drive IC device 22 is mounted on a flexible resin plate 21 by a tape automated bonding method. An electrode pattern 23 on the flexible resin plate 21 is electrically connected to an electrode pattern 11 on a connection portion (glass plate) 12 of the liquid crystal panel 1.

The electrode pattern 11 on the liquid crystal panel 1 and the electrode pattern 23 on the flexible resin plate 21 are connected by the processes shown in Figs. 4 to 7.

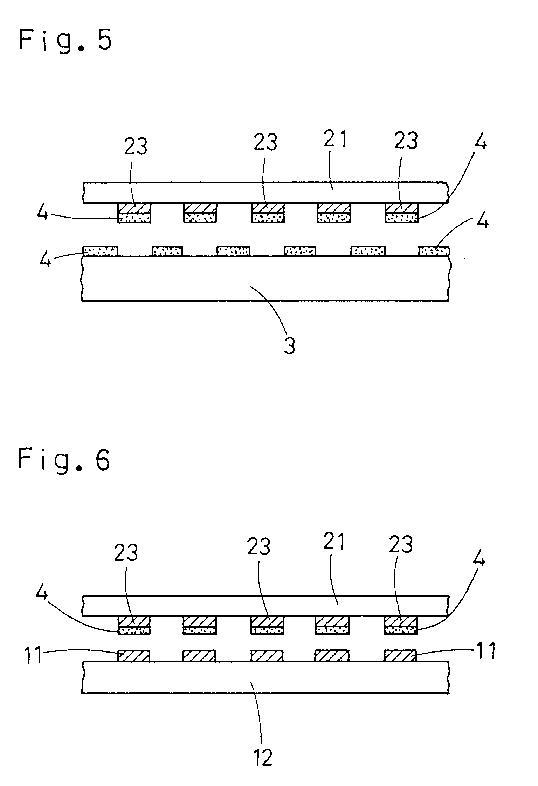

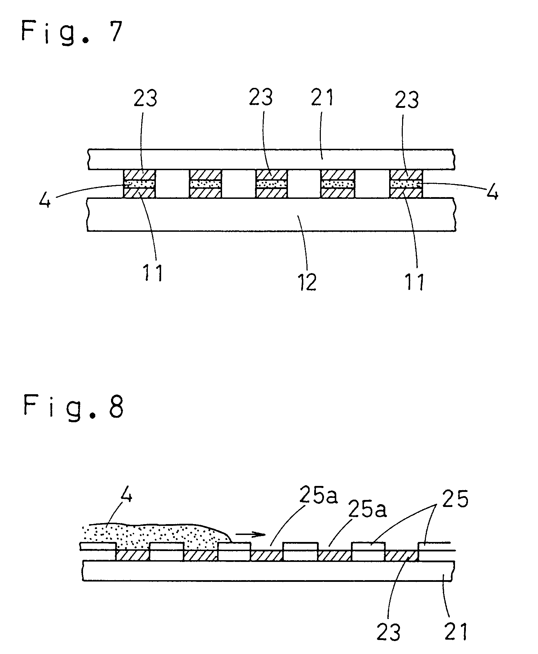

First, as shown in Fig. 4, conductive metal paste (carbon paste in this embodiment) 4 is applied with a thickness of 5 $\mu$m to 10 $\mu$m on a stage 3. Then, the electrode patterns 23 on the flexible resin plate 21 are arranged thereabove, and pressure is applied on the carbon paste 4 while the parallelism with the stage 3 is maintained. Thereby, as shown in Fig. 5, the carbon paste 4 is transferred only onto the electrode patterns 23 on the flexible resin plate 21. Then, as shown in Fig. 6, the electrode patterns 11 on the connection portion 12 of the liquid crystal 1 and the electrode patterns 23 on the flexible resin plate 21 are positioned (position-adjusted) so as to be opposite to each other in a vertical direction, and as shown in Fig. 7, the electrode patterns 11 and 23 in contact with each other through the carbon paste 4 are heated and pressurized. In this embodiment, the electrode patterns 11 and 23 are heated at 100 °C for 30 ms. The carbon paste 4 is hardened to some extent by this heating and pressurizing. Thereafter, under the condition where the carbon paste 4 applied therebetween is hardened to some extent, the electrode patterns 11 and 23 are further heated at 60 °C for approximately 30 minutes to completely harden the carbon paste 4 (this process is not shown). Thereby, the electrode patterns 23 (drive circuit side electrode patterns) on the flexible resin plate 21 and the electrode patterns 11 on the connection portion 12 of on the liquid crystal panel 1 are conductively pasted together completely.

According to the above-described method of connecting electrodes of a display apparatus, the conductive metal paste (carbon paste) 4 is transferred onto the electrode pattern 23 on the flexible resin plate (such as a flexible printed plate) 21 where the drive IC device 22 is provided, and the electrode pattern 23 on the flexible resin plate 21 and the electrode pattern 11 on the connection portion 12 of the liquid crystal panel 1 are heated and pressurized so that they are conductively pasted together through the carbon paste 4. Thus, since it is not a resin pasting but a metal paste pasting, adhesive strength highly resistant to heat is obtained. Thereby, high quality reliability is realized.

While the carbon paste 4 is applied on the entire surface of the stage 3 in this embodiment, it may be applied on the stage 3 by use of a mask so that it is applied on portions corresponding to the electrode patterns 23 on the flexible resin plate 21.

Moreover, the carbon paste may be directly applied to the electrode pattern 23 on the flexible resin plate 21 by a screen printing method as shown in Fig. 8. In that case, the stage 3 and the process of applying the carbon paste 4 to the stage 3 are unnecessary. In Fig. 8, the carbon paste is formed on the electrode pattern 23 by moving the carbon paste 4 in a direction of the arrow on a screen 25 having holes 25a.

Obviously, many modifications and variations of the present invention are possible in light of the above teachings. It is therefore to be understood that within the scope of the appended claims, the invention may be practiced other than as specifically described.

**Claims**

1. A method of connecting electrodes of a display apparatus comprising:

   a process of forming conductive metal paste on an electrode pattern on a flexible resin plate where a drive circuit device is mounted; and

   a process of position-adjusting the electrode pattern on which the conductive metal paste is provided and the electrode pattern on a plane-type display body to heat and pressurize them,

   wherein the electrode pattern on the display body and the electrode pattern on the drive circuit side are connected to each other through the conductive metal paste.

2. A method of connecting electrodes according to claim 1, wherein said process of forming the conductive metal paste on the electrode pattern on the flexible resin plate comprises a process of applying the conductive metal paste to the entire surface of a stage and a process of pressing the surface where the flexible resin plate is formed onto the upper surface of said stage where the conductive metal paste is applied and thereafter retiring it from the upper surface of the stage.

3. A method of connecting electrodes according to claim 1, wherein said process of forming the conductive metal paste on the electrode pattern on the flexible resin plate comprises a process of directly applying the conductive metal paste to the electrode pattern on said flexible resin plate by a screen printing method.

Fig. 1    prior art

Fig. 2    prior art

Fig. 3

Fig. 4

Fig. 5

Fig. 6

Fig. 7

Fig. 8

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| A | GB-A-2 202 999 (P A CONSULTING SERVICES LTD.)<br>* abstract *<br>--- | 1 | H01R23/68<br>G02F1/1345 |
| A | EP-A-0 397 304 (SHARP KABUSHIKI KAISHA)<br>* abstract; figure 3 *<br>--- | 1 | |
| A | US-A-4 411 633 (WALDRON)<br>* abstract; figures 2,3 *<br>--- | 1 | |
| A | US-A-4 243 455 (SHIBA ET AL.)<br>* abstract; figure 4 *<br>----- | 1 | |
| | | | TECHNICAL FIELDS SEARCHED (Int. Cl.5 )<br><br>H01R<br>G02F<br>H05K |

The present search report has been drawn up for all claims

| Place of search | Date of completion of the search | Examiner |
|---|---|---|
| THE HAGUE | 10 JUNE 1992 | HORAK A. L. |